# EUROPEAN PATENT SPECIFICATION

(11) **EP 3 295 249 B1**
(45) Date of publication and mention of the grant of the patent: **20.03.2019**
(21) Application number: 16726012.4
(22) Date of filing: 13.05.2016
(51) Int. Cl.: G03F 7/20

(54) **ILLUMINATION SYSTEM OF A MICROLITHOGRAPHIC PROJECTION APPARATUS AND METHOD OF ADJUSTING AN IRRADIANCE DISTRIBUTION IN SUCH A SYSTEM**
BELEUCHTUNGSSYSTEM EINER MIKROLITHOGRAPHISCHEN PROJEKTIONSVORRICHTUNG UND VERFAHREN ZUR EINSTELLUNG EINER BESTRAHLUNGSVERTEILUNG IN SOLCH EINEM SYSTEM
SYSTÈME D'ÉCLAIRAGE D'UN APPAREIL DE PROJECTION MICROLITHOGRAPHIQUE, ET PROCÉDÉ DE RÉGLAGE DE DISTRIBUTION D'ÉCLAIREMENT ÉNERGÉTIQUE DANS UN TEL SYSTÈME

(30) Priority: 13.05.2015 DE 102015208949
(43) Date of publication of application: 21.03.2018
(73) Proprietor: Carl Zeiss SMT GmbH, 73447 Oberkochen (DE)
(72) Inventor: DAVYDENKO, Vladimir, 76332 Bad Herrenalb (DE)
(74) Representative: Ostertag & Partner Patentanwälte mbB
(86) International application number: PCT/EP2016/000794
(87) International publication number: WO 2016/180541

(56) References cited:
- US-A1- 2012 202 157
- US-A1- 2013 293 861
- US-A1- 2014 293 254

## Description

### 1. Field of the Invention

The invention generally relates to the field of microlithography, and in particular to illumination systems used in projection exposure apparatus or mask inspection apparatus. The invention is particularly concerned with adjusting a light irradiance distribution on a surface in such illumination systems. The surface may be a field plane or a pupil plane, for example, and it may also be a boundary surface of an optical element such as an optical integrator.

### 2. Description of Related Art

Microlithography (also referred to as photolithography or simply lithography) is a technology for the fabrication of integrated circuits, liquid crystal displays and other microstructured devices. The process of microlithography, in conjunction with the process of etching, is used to pattern features in thin film stacks that have been formed on a substrate, for example a silicon wafer. At each layer of the fabrication, the wafer is first coated with a photoresist which is a material that is sensitive to radiation, such as deep ultraviolet (DUV), vacuum ultraviolet (VUV) or extreme ultraviolet (EUV) light. Next, the wafer with the photoresist on top is exposed to projection light in a projection exposure apparatus. The apparatus projects a mask containing a pattern onto the photoresist so that the latter is only exposed at certain locations which are determined by the mask pattern. After the exposure the photoresist is developed to produce an image corresponding to the mask pattern. Then an etch process transfers the pattern into the thin film stacks on the wafer. Finally, the photoresist is removed. Repetition of this process with different masks results in a multilayered microstructured component.

A projection exposure apparatus typically includes a light source, an illumination system that illuminates the mask with projection light produced by the light source, a mask stage for aligning the mask, a projection objective and a wafer alignment stage for aligning the wafer coated with the photoresist. The illumination system illuminates a field on the mask that may have the shape of a rectangular or curved slit, for example.

In current projection exposure apparatus a distinction can be made between two different types of apparatus. In one type each target portion on the wafer is irradiated by exposing the entire mask pattern onto the target portion in one go. Such an apparatus is commonly referred to as a wafer stepper. In the other type of apparatus, which is commonly referred to as a step-and-scan apparatus or scanner, each target portion is irradiated by progressively scanning the mask pattern under the projection beam along a scan direction while synchronously moving the substrate parallel or anti-parallel to this direction. The ratio of the velocity of the wafer and the velocity of the mask is equal to the magnification of the projection objective, which is usually smaller than 1, for example 1:4.

It is to be understood that the term "mask" (or reticle) is to be interpreted broadly as a patterning means. Commonly used masks contain opaque or reflective patterns and may be of the binary, alternating phase-shift, attenuated phase-shift or various hybrid mask type, for example. However, there are also active masks, e.g. masks realized as a programmable mirror array. Also programmable LCD arrays may be used as active masks.

In a mask inspection apparatus a mask to be inspected is not projected on a resist, but on an electronic imaging device such as a CCD camera. The aerial image produced by the objective on the imaging device is not reduced as in exposure apparatus, but strongly magnified. The illumination systems of projection exposure apparatus and mask inspection apparatus are quite similar, however.

As the technology for manufacturing microstructured devices advances, there are ever increasing demands also on the illumination system. Ideally, the illumination system illuminates each point of the illuminated field on the mask with projection light having a well defined angular and spatial irradiance distribution.

### a) Adjustment of Angular Irradiance Distribution

The term angular irradiance distribution describes how the total light energy of a light bundle, which converges towards a particular point in the mask plane, is distributed among the various directions of the rays that constitute the light bundle.

The angular irradiance distribution of the projection light impinging on the mask is usually adapted to the kind of pattern to be projected onto the photoresist. Often the angular irradiance distribution depends on the size, orientation and pitch of the features contained in the pattern. The most commonly used angular irradiance distributions of projection light are referred to as conventional, annular, dipole and quadrupole illumination settings. These terms refer to the irradiance distribution in a pupil plane of the illumination system. With an annular illumination setting, for example, only an annular region is illuminated in the pupil plane. Thus there is only a small range of angles present in the angular irradiance distribution of the projection light, and all light rays impinge obliquely with similar angles onto the mask.

If the angular irradiance distribution unintentionally varies over the illuminated field on the mask, this usually has a negative impact on the quality of the image that is produced on the light sensitive surface. For example, if the angular irradiance distribution is not perfectly balanced, i. e. more light impinges from one side on a mask point than from the opposite side, the conjugate image point on the light sensitive surface will be laterally shifted if the light sensitive surface is not perfectly arranged in the focal plane of the projection objective.

Different means are known in the art to adjust the angular irradiance distribution of the projection light in the mask plane so as to achieve the desired illumination setting. Most prior art approaches focus on adjusting the spatial irradiance distribution in the pupil plane of the illumination system.

In the simplest case a stop (diaphragm) comprising one or more apertures is positioned in the pupil plane. Since locations in a pupil plane translate into angles in a Fourier related field plane such as the mask plane, the size, shape and location of the aperture(s) in the pupil plane determines the angular irradiance distributions in the mask plane. However, any change of the illumination setting requires a replacement of the stop. This makes it difficult to finely adjust the illumination setting, because this would require a very large number of stops that have aperture(s) with slightly different sizes, shapes or locations. Furthermore, the use of stops inevitably results in significant light losses and thus in a reduced throughput of the apparatus.

Many common illumination systems therefore comprise adjustable elements that make it possible, at least to a certain extent, to continuously adjust the irradiance distribution in the pupil plane. Many illumination systems use an exchangeable diffractive optical element that produces a desired spatial irradiance distribution in the pupil plane. With zoom optics and a pair of axicon elements provided between the diffractive optical element and the pupil plane, it is possible to adjust this spatial irradiance distribution to some extent.

Some years ago it has been proposed to use mirror arrays that variably illuminate the pupil plane. In EP 1 262 836 A1 the mirror array is realized as a micro-electromechanical system (MEMS) comprising more than 1000 microscopic mirrors. Each of the mirrors produces a light spot in the pupil plane. Since the mirrors can be tilted about two orthogonal axes, it is possible to freely move the spots across the pupil plane by tilting the mirrors.

Similar illumination systems are known from US 2006/0087634 A1, US 7,061,582 B2, US 2007/0165202 A1 and US 2011/0122388 A1.

It has also been proposed to adjust the angular irradiance distribution in a field dependent manner by variably illuminating light entrance facets of an optical integrator. Such an approach is disclosed in US 2013/0293861 A1. In this prior art illumination system a first mirror array is used to produce a desired irradiance distribution in the pupil plane of the illumination system. In close proximity to the pupil plane an optical integrator is arranged that has a plurality of light entrance facets. Images of the light entrance facets are superimposed on the mask. The light spots produced by the first mirror array have an area that is at least five times smaller than the total area of the light entrance facets. Thus it is possible to produce variable light patterns on the light entrance facets. In this manner different angular irradiance distributions can be produced on different portions of the illumination field. It is thus possible, for example, to produce an X dipole and a Y dipole illumination setting at a given time in the illumination field.

In order to ensure that the portions with different illumination settings are sharply delimited, a second mirror array configured as a digital mirror device (DMD) is used in the prior art illumination system. This second mirror array is illuminated by the first mirror array and is imaged on the light entrance facets by an objective. By bringing larger groups of micromirrors of the second mirror array in an "off"-state, it is possible to produce irradiance distributions on the light entrance facets that have sharp boundaries.

According to international patent application PCT/EP2014/003049 (published as WO2015074746) the second mirror array is not only used for ensuring sharp boundaries, but also to directly determine the light patterns on the light entrance facets. Then the light spots produced by the first mirror array may also be larger than the light entrance facets.

### b) Adjustment of Spatial Irradiance Distribution

As mentioned further above, it is usually desired to illuminate, at least after scan integration, all points on the mask with the same irradiance distribution. If points on the mask are illuminated with different irradiances after scan integration, this usually results in undesired variations of the critical dimension (CD) at wafer level. For example, in the presence of irradiance variations the image of a uniform line on the mask on the light sensitive may also have irradiance variations along its length. Because of the fixed exposure threshold of the resist, such irradiance variations directly translate into widths variations of a structure that shall be defined by the image of the line.

For modifying the spatial irradiance distribution in the illumination field US 6,404,499 A and US 2006/0244941 A1 propose mechanical devices that comprise two opposing arrays of opaque finger-like stop elements that are arranged side by side and aligned parallel to the scan direction. Each pair of mutually opposing stop elements can be displaced along the scan direction so that the distance between the opposing ends of the stop elements is varied. If this device is arranged in a field plane of the illumination system that is imaged by an objective on the mask, it is possible to produce a slit-shaped illumination field whose width along the scan direction may vary along the cross-scan direction. Since the irradiance is integrated during the scan process, the integrated irradiance (sometimes also referred to as illumination dose) can be finely adjusted for a plurality of cross-scan positions in the illumination field.

However, these devices are mechanically very complex and expensive. This is also due to the fact that they have to be arranged in or very close to a field plane in which usually the blades of a movable field stop is arranged.

### SUMMARY OF THE INVENTION

It is therefore an object of the present invention to provide an illumination system of a microlithographic projection apparatus which makes it possible to finely adjust a given spatial irradiance distribution on a surface without incurring significant light losses. The surface may be a pupil plane, a field plane or a plane between a pupil and a field plane.

This object is achieved, in accordance with the present invention, by an illumination system of a microlithographic projection apparatus comprising a light entrance configured to receive projection light that is produced by a light source, and an irradiance adjustment unit arranged to receive projection light - directly or preferably via intermediate optical elements - from the light entrance and configured to adjust an irradiance distribution of the projection light on a surface. The irradiance adjustment unit comprises a spatial light modulator having an array of light deflection elements that are configured to be individually controlled, and a light splitter that splits the projection light into modulated light that propagates along a modulation light path and non-modulated light that propagates along a non-modulation light path which is distinct from the modulation light path. The spatial light modulator is only arranged in the modulation light path, and no spatial light modulator is arranged in the non-modulation light path. The modulated light and the non-modulation light superimpose on the surface.

The term "modulated light" is used herein to denote light that has already been modulated, or is going to be modulated, by the spatial light modulator. Similarly, the term "non-modulated light" is used herein to denote light the has note been modulated and is not going to be modulated by the spatial light modulator. The term "light" encompasses not only DUV and VUV, but also EUV light.

The invention is based on the conception that in the field of lithography it is often necessary to finely adjust an irradiance distribution that has been produced by other optical elements. This implies that most of the projection light does not have to be modulated at all. Since the use of a spatial light modulator inevitably results in light losses, a part of the projection light - and preferably the greatest part of it - is not directed, in accordance with the invention, to a spatial light modulator, but directly propagates along the non-modulation light path towards the surface. Since this non-modulated light has not interacted with a spatial light modulator, its irradiance and other optical properties such as polarization remain completely unaffected by the spatial light modulator. Only the residual (usually small) part of the projection light that has been directed by the light splitter towards the spatial light modulator undergoes a modulation. The modulation usually implies a spatially resolved attenuation of this part of the projection light, but sometimes also unintentional light losses or changes of other optical properties. But since only a (preferably small) part of the projection light interacts with the spatial light modulator, any adverse effects which may be attributed to the spatial light modulator can be kept to a minimum.

On the other hand, the available spatial light modulators such as digital mirror devices or LCD-panels are very effective, reliable and fast devices for adjusting a spatial irradiance distribution. The invention makes it possible to use these sophisticated devices whilst keeping any adverse effects usually involved with their use to a minimum.

With the help of beam combiners it is possible to combine the modulation light path and the non-modulation light paths so that the modulated light and the non-modulated light impinges from the same direction on the surface where the irradiance distribution shall be adjusted. In some applications, however, the directions of incidence of the projection light does not matter, and the beam combiners can be dispensed with. Then an angle of incidence of the non-modulated light on the surface may be less than 5° for example, and an angle of incidence of the modulated light on the surface may be greater than 5°, for example.

Preferably the light splitter is configured such that at least 70%, and preferably more than 80%, of the projection light impinging on the irradiance adjustment unit propagates along the non-modulation light path. The larger the percentage of light is that propagates along the non-modulation light path, the smaller are any adverse effects that the spatial light modulator may have on the projection light.

In some embodiments the light splitter comprises a beam splitter surface. Such surfaces may be contained in a conventional beam splitter cube, for example.

In other embodiments the light splitter comprises a diffractive optical element configured to produce at least two diffraction orders if illuminated with the projection light. In this context also the zeroth order light is considered as a diffraction order of the diffractive optical element.

In one embodiment the diffractive optical element is reflective and arranged such that the projection light impinges on the diffractive optical element under grazing incidence. This makes it possible to produce from a projection light beam having a small diameter a split-off projection light beam having a much larger cross section, because any non-zero diffraction order is reflected from the diffractive optical element with a reflection angle that differs from the angle of incidence.

More specifically, zeroth order light emerging from the light splitter may form a first portion of the non-modulated light, and non-zeroth order light emerging from the light splitter may impinge on a second diffractive optical element under grazing incidence, which splits it into the modulated light and a second portion of the non-modulated light. With such a configuration an almost lossless configuration of the light splitter can be achieved, and the light splitter requires only a small volume within the illumination system.

In such a configuration the second portion of the non-modulated light may impinge on a third diffractive optical element from which all diffraction orders are guided towards the surface.

As a matter of course it is possible to provide not only one modulation light path and one non-modulation light path, but a plurality of such light paths. For example, the irradiance adjustment unit may comprise a further spatial light modulator having an array of further light deflection elements that are configured to be individually controlled. The light splitter splits the projection light also into a further modulated light that propagates along a further modulation light path. The further spatial light modulator is arranged in the further modulation light path, and the modulated light, the further modulated light and the non-modulated light superimpose on the surface.

In that case it is envisioned to use diffractive optical elements in the light splitter that produce at least three diffraction orders.

In some embodiments the light deflection elements of the spatial light modulator are mirrors that are configured to be tilted around a tilt axis. Such a spatial light modulator may be configured as a digital mirror device (DMD).

In some embodiments the illumination system comprises an objective that images the spatial light modulator on the surface. Then the modulated irradiance distribution on the spatial light modulator is is reproduced, possibly with a magnification distinct from 1, on the surface.

The illumination system may comprise a mask plane in which a mask to be illuminated by the projection light can be arranged, and an optical integrator configured to produce a plurality of secondary light sources. The optical integrator comprises a plurality of light entrance facets each being associated with one of the secondary light sources and arranged on the surface. Images of the light entrance facets at least substantially superimpose in the mask plane. The illumination system further comprises a pupil forming unit that is configured to variably illuminate the irradiance adjustment unit. With such a configuration the irradiance adjustment unit may be used to finely adjust the angular light distribution at mask level in a field dependent manner.

The pupil forming unit that variably illuminates the irradiance adjustment unit may comprise an array of beam deflection elements each being configured to illuminate a spot on the spatial light modulator at a position that is continuously variable by changing a deflection angle produced by the beam deflection element. Such beam deflection elements may be realized as micromirrors that can be continuously tilted around two tilt axes for example, or acousto-optical elements.

Subject of the invention is also a method of adjusting an irradiance distribution of projection light on a surface of an illumination system of a microlithographic projection apparatus. The method comprises the following steps:
a) splitting the projection light into modulated light and non-modulated light;
b) directing the modulated light to a spatial light modulator and from the spatial light modulator to the surface;
c) directing the non-modulated light on the surface so that the non-modulated light, without interacting with a spatial light modulator, superimposes with the modulated light on the surface.

At least 70% of the projection light may propagate along the non-modulation light path.

A diffractive optical element may split the projection light in step a).

The projection light may impinge on the diffractive optical element under grazing incidence.

Zeroth order light emerging from the light splitter may form a first portion of the non-modulated light. Non-zeroth order light emerging from the light splitter may impinge on a second diffractive optical element under grazing incidence, which splits it into the modulated light and a second portion of the non-modulated light.

The second portion of the non-modulated light may impinge on a third diffractive optical element from which all diffraction orders are guided towards the surface.

The spatial light modulator may be imaged on a surface.

In one embodiment an optical integrator produces a plurality of secondary light sources. The optical integrator comprises a plurality of light entrance facets each being associated with one of the secondary light sources and arranged on the surface. Images of the light entrance facets are at least substantially superimposed in the mask plane.

A pupil forming unit variably illuminates the irradiance adjustment unit.

### DEFINITIONS

The term "light" is used herein to denote any electromagnetic radiation, in particular visible light, UV, DUV, VUV and EUV light and X-rays.

The term "light ray" is used herein to denote light whose path of propagation can be described by a line.

The term "light bundle" is used herein to denote a plurality of light rays that have a common origin in specific point.

The term "light beam" is used herein to denote all light that passes through a particular lens or another optical element. The term "orientation" is used herein to denote how a body is angularly oriented in the three-dimensional space. The orientation is usually indicated by a set of three angles.

The term "position" is used herein to denote the location of a reference point of a body in the three-dimensional space. The position is usually indicated by a set of three Cartesian coordinates. The orientation and the position therefore fully describe the placement of a body in the three-dimensional space.

The term "surface" is used herein in a mathematical sense to denote any two-dimensional area in the three-dimensional space. The surface may be an outside part of a body or may be completely separated from a body, as it is usually the case with a field or a pupil plane.

The term "field plane" is used herein to denote the mask plane or any other plane that is optically conjugate to the mask plane.

The term "pupil plane" is a plane in which (at least approximately) a Fourier relationship is established to a field plane. Generally marginal rays passing through different points in the mask plane intersect in a pupil plane, and chief rays intersect the optical axis. As usual in the art, the term "pupil plane" is also used if it is in fact not a plane in the mathematical sense, but is slightly curved so that, in the strict sense, it should be referred to as pupil surface.

The term "uniform" is used herein to denote a property that does not depend on the position.

The term "optical raster element" is used herein to denote any optical element, for example a lens, a prism or a diffractive optical element, which is arranged, together with other identical or similar optical raster elements so that each optical raster element is associated with one of a plurality of adjacent optical channels.

The term "optical integrator" is used herein to denote an optical system that increases the product *NA*·*a*, wherein *NA* is the numerical aperture and *a* is the illuminated field area.

The term "condenser" is used herein to denote an optical element or an optical system that establishes (at least approximately) a Fourier relationship between two planes, for example a field plane and a pupil plane.

The term "conjugated plane" is used herein to denote planes between which an imaging relationship is established. Such a relationship is characterized in that a light bundle diverging from an object point converges in a point in the conjugated image plane.

The term "field dependence" is used herein to denote any functional dependence of a physical quantity from the position in a field plane.

The term "spatial irradiance distribution" is used herein to denote how the total irradiance varies over a real or imaginary surface on which light impinges. Usually the spatial irradiance distribution can be described by a function *Iₛ(x*, *y)*, with *x*, *y* being spatial coordinates of a point on the surface.

The term "angular irradiance distribution" is used herein to denote how the irradiance of a light bundle varies depending on the angles of the light rays that constitute the light bundle. Usually the angular irradiance distribution can be described by a function *Iₐ(α*, *β)*, with *α*, β being angular coordinates describing the directions of the light rays. If the angular irradiance distribution has a field dependence, *Iₐ* will be also a function of field coordinates, i. e. *Iₐ*= *Iₐ (α*, *β*, *x*, *y).* The field dependence of the angular irradiance distribution may be described by a set of expansion coefficients *aᵢⱼ* of a Taylor (or another suitable) expansion of *Iₐ (α*, *β*, *x*, *y)* in *x*, *y*.

### BRIEF DESCRIPTION OF THE DRAWINGS

Various features and advantages of the present invention may be more readily understood with reference to the following detailed description taken in conjunction with the accompanying drawings in which:
- FIG. 1: is a schematic perspective view of a projection exposure apparatus in accordance with one embodiment of the present invention;
- FIG. 2: is an enlarged perspective view of a particular mask to be projected by the projection exposure apparatus shown in FIG. 1, illustrating various deficiencies of the angular irradiance distribution;
- FIG. 3: is a meridional section through an illumination system being part of the apparatus shown in FIG. 1;
- FIG. 4: is a perspective view of a mirror array contained in the illumination system shown in FIG. 3;
- FIG. 5: is a perspective view of one of the spatial light modulators contained in the illumination system shown in FIG. 3;
- FIG. 6: is a perspective view of an optical integrator contained in the illumination system shown in FIG. 3;
- FIG. 7: is a very schematic meridional section through the mirror array and one of the spatial light modulators shown in FIGS. 4 and 5;
- FIG. 8: is a perspective view on the spatial light modulator shown in FIG. 5, but illuminated with two poles;
- FIG. 9: is a perspective view of the optical integrator shown in FIG. 6, but illuminated with two poles;
- FIG. 10: is a schematic meridional section through a portion of the illumination system in which only optical raster elements of the optical integrator and a condenser are shown;
- FIGS. 11a: and 11b are top views on one of the spatial light modulators and the optical integrator shown in FIG. 3, respectively;
- FIG. 12: illustrates an irradiance distribution on a light entrance facet of the optical integrator;
- FIG. 13: is a graph showing the scan integrated irradiance distribution along the X direction produced by the light entrance facet shown in FIG. 12;
- FIG. 14: illustrates another irradiance distribution on a light entrance facet of the optical integrator;
- FIG. 15: is a graph showing the scan integrated irradiance distribution along the X direction produced by the light entrance facet shown in FIG. 14;
- FIG. 16: is a meridional section through an irradiance attenuation unit according to a second embodiment in which the light splitter is configured as a diffractive optical element;
- FIG. 17: is a perspective view of an irradiance attenuation unit according to a third embodiment in which projection light impinges on several diffractive optical elements under grazing incidence;
- FIG. 18: is a cross sectional view of the irradiance attenuation unit shown in FIG. 17 in an XZ plane;
- FIG. 19: is a cross sectional view of the irradiance attenuation unit shown in FIG. 17 in an YZ plane; and
- FIG. 20: is a flow diagram illustrating important method steps.

### DESCRIPTION OF PREFERRED EMBODIMENTS

### I. General Construction of Projection Exposure Apparatus

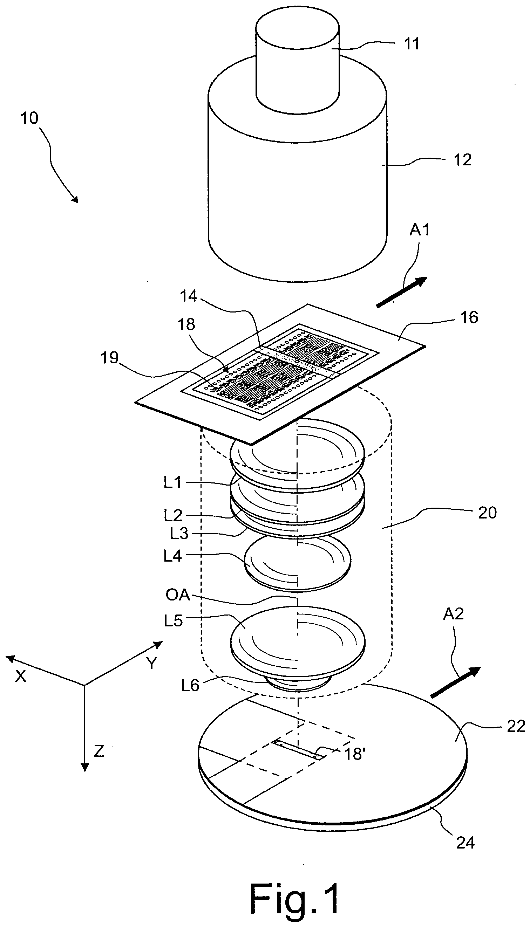

FIG. 1 is a perspective and highly simplified view of a projection exposure apparatus 10 in accordance with the present invention. The apparatus 10 comprises a light source 11 that may be realized as an excimer laser, for example. The light source 11 in this embodiment produces projection light having a center wavelength of 193 nm. Other wavelengths, for example 157 nm or 248 nm, are envisaged as well.

The apparatus 10 further comprises an illumination system 12 which conditions the projection light provided by the light source 11 in a manner that will be explained below in further detail. The projection light emerging from the illumination system 12 illuminates an illumination field 14 on a mask 16. The mask 16 contains a pattern 18 formed by a plurality of small features 19 that are schematically indicated in FIG. 1 as thin lines. In this embodiment the illumination field 14 has the shape of a rectangle. However, other shapes of the illuminated field 14, for example a ring segment, are also contemplated.

A projection objective 20 comprising lenses L1 to L6 images the pattern 18 within the illumination field 14 onto a light sensitive layer 22, for example a photoresist, which is supported by a substrate 24. The substrate 24, which may be formed by a silicon wafer, is arranged on a wafer stage (not shown) such that a top surface of the light sensitive layer 22 is precisely located in an image plane of the projection objective 20. The mask 16 is positioned by means of a mask stage (not shown) in an object plane of the projection objective 20. Since the latter has a magnification β with |β|<1, a minified image 18' of the pattern 18 within the illumination field 14 is projected onto the light sensitive layer 22.

During the projection the mask 16 and the substrate 24 move along a scan direction which corresponds to the Y direction indicated in FIG. 1. The illumination field 14 then scans over the mask 16 so that patterned areas larger than the illumination field 14 can be continuously imaged. The ratio between the velocities of the substrate 24 and the mask 16 is equal to the magnification β of the projection objective 20. If the projection objective 20 does not invert the image (β>0), the mask 16 and the substrate 24 move along the same direction, as this is indicated in FIG. 1 by arrows A1 and A2. However, the present invention may also be used in stepper tools in which the mask 16 and the substrate 24 do not move during projection of the mask.

### II. Field Dependent Angular Irradiance Distribution

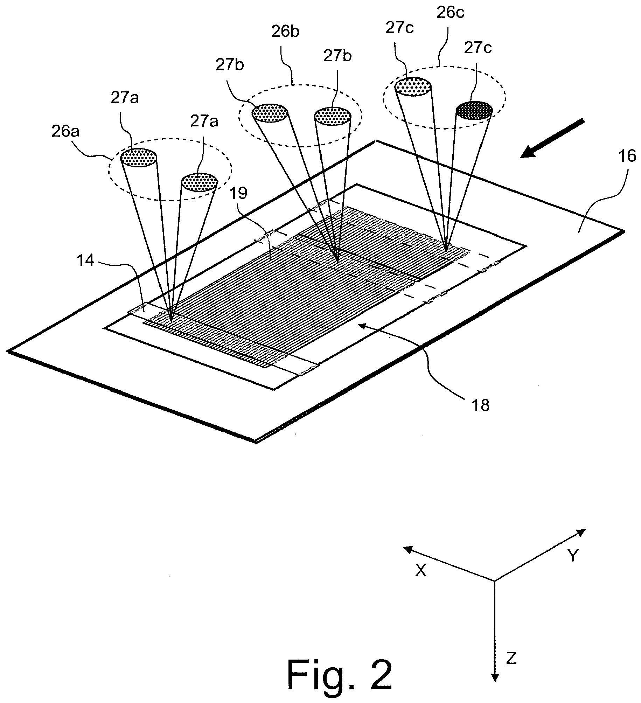

FIG. 2 is an enlarged perspective view of the mask 16 containing another exemplary pattern 18. For the sake of simplicity it is assumed that the pattern 18 comprises only features 19 that extend along the Y direction. It is further assumed that the features 19 extending along the Y direction are best imaged on the light sensitive layer 22 with an X dipole illumination setting.

In FIG. 2 an exit pupil 26a associated with a light bundle is illustrated by a circle. The light bundle converges towards a field point that is located at a certain X position of the illumination field 14 at a first time during a scan cycle. In the exit pupil 26a two poles 27a, which are spaced apart along the X direction, represent directions from which projection light propagates towards this field point. The light energies concentrated in each pole 27a are assumed to be equal. Thus the projection light impinging from the +X direction has the same energy as the projection light impinging from the -X direction. Since the features 19 are assumed to be uniformly distributed over the pattern 18, this X dipole illumination setting should be produced at each field point on the mask 16.

Another exit pupil denoted by 26b is associated with a light bundle that converges towards a field point that is located at another X position of the illumination field 14 at a later time of the scan cycle. The light energies concentrated in each pole 27b are again equal. However, the light associated with the poles 27b are tilted compared to the light cones of light that are associated with the ideal pole 27a. This means that the field point receives the same amount of projection light, but the directions from which the projection light impinges on the field point are not ideal for imaging the features 19 on the light sensitive layer 22.

A further exit pupil denoted by 26c is associated with a point in the illuminated field 14 that is located at still another X position. Here it is assumed that the directions from which the projection light impinges on the field point are again ideal for imaging the features 19. Therefore also the light cones associated with the poles 27c have the same cone angle and orientation as the cones associated with the ideal exit pupil 26a. However, the poles 27c are not balanced, i.e. the light energy concentrated in the poles 27c differs from one another. Thus the projection light impinging from the +X direction has less energy than the projection light impinging from the -X direction.

From the foregoing it becomes clear that the ideal angular irradiance distribution represented by the exit pupil 26a is not obtained at each X position in the illumination field 14. The angular irradiance distribution is therefore field-dependent, i.e. at different field points the angular irradiance distribution is different.

A field dependence may not only occur along the X direction, but also along the Y direction within the illumination field 14. Then one point on the mask 16 experiences different angular irradiance distributions while it passes through the illumination field 14 during a scan cycle. If a field dependence along the Y direction (i.e. the scan direction) occurs, it has to be taken into account that the total effect for a particular field point is obtained by integrating the different angular irradiance distributions.

There is a wide variety of further field-dependent deviations of a real angular irradiance distribution from the ideal one. For example, the poles in the exit pupil associated with some field points may be deformed, blurred or may not have a desired non-uniform irradiance distribution.

If field dependent deviations from the ideal angular irradiance distribution occur, this generally has a negative impact on the quality of the pattern image that is formed on the light sensitive layer 22. In particular, the dimensions of the structures that are produced with the help of the apparatus 10 may vary inadvertently, and this may compromise the function of the devices containing these structures. Therefore it is generally desired to eliminate any field dependence of the illumination setting in the illumination field 14.

Sometimes, however, it is desirable to deliberately introduce a field dependence of the angular irradiance distribution. This may be expedient, for example, if the projection objective 20 or the mask 16 has field depending properties that affect the image of the pattern 18 on the light sensitive layer 22. Variations of the imaging properties of the projection objective 20 may occur as a result of manufacturing tolerances, aging phenomena or non-uniform temperature distributions, for example. A field dependence of the mask 16 often occurs as a result of features that have different orientations or dimensions, for example. Often field dependent adverse effects can be successfully reduced by selectively introducing a field dependence of the angular irradiance distribution. Since some of these effects change very rapidly, it is sometimes desired to change the field dependence of the angular irradiance distribution during a single scan cycle.

### III. Construction of Illumination System

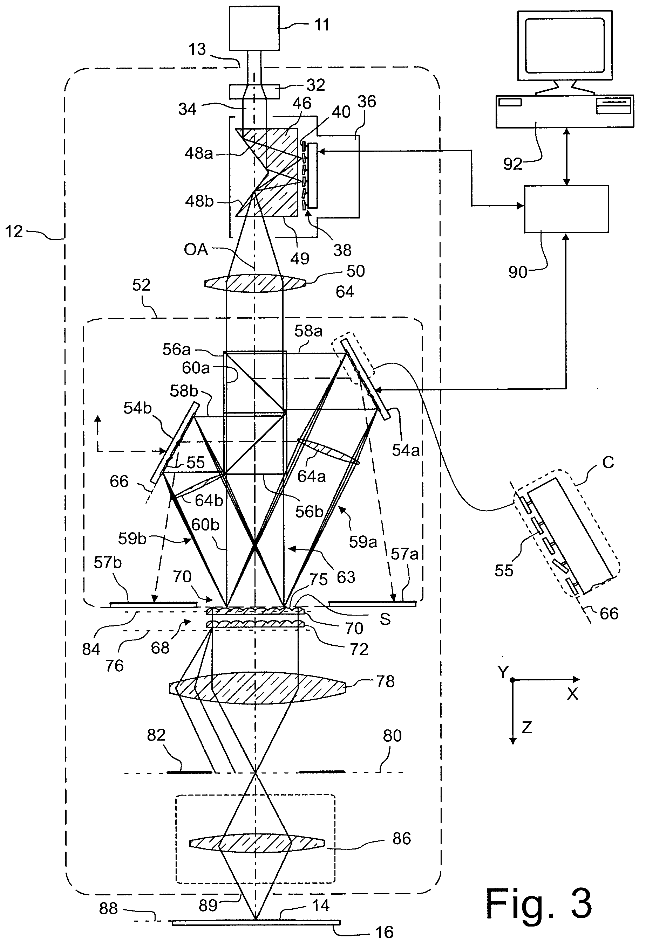

FIG. 3 is a meridional section through the illumination system 12 shown in FIG. 1. For the sake of clarity, the illustration of FIG. 3 is considerably simplified and not to scale. This particularly implies that different optical units are represented by one or very few optical elements only. In reality, these units may comprise significantly more lenses and other optical elements.

In the embodiment shown, the projection light emitted by the light source 11 enters the illumination system 12 through a light entrance 13, which may be formed by an opening or a pane of glass provided in a housing. The projection light is expanded in a beam expansion unit 32 which outputs an almost collimated light beam 34. To this end the beam expansion unit 32 may comprise several lenses or may be realized as a mirror arrangement, for example.

### 1. Pupil Forming Unit

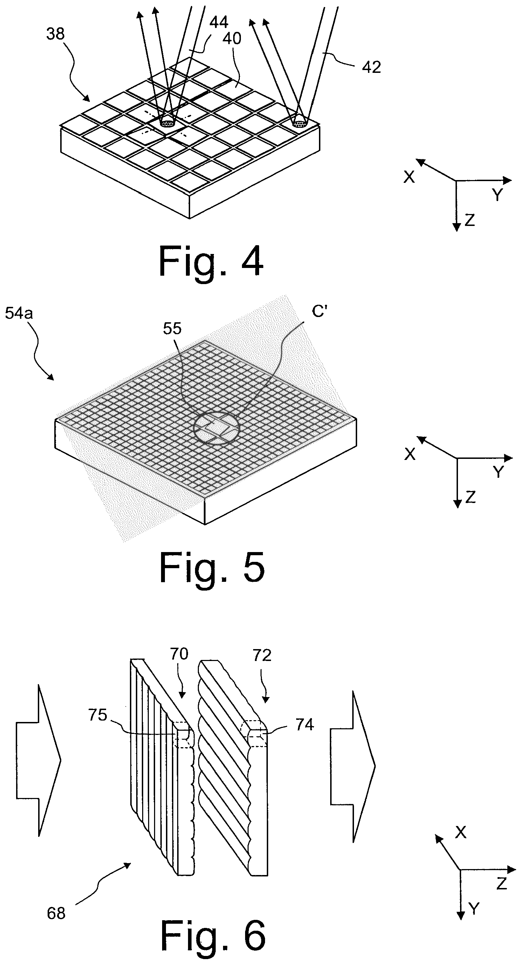

The projection light beam 34 then enters a pupil forming unit 36 that produces variable spatial irradiance distributions in a subsequent plane. To this end the pupil forming unit 36 comprises an array 38 of small mirrors 40 that can be tilted individually about two orthogonal axes with the help of actuators. FIG. 4 is a perspective view of the mirror array 38 illustrating how two parallel light beams 42, 44 are reflected into different directions depending on the tilting angles of the mirrors 40 on which the light beams 42, 44 impinge. In FIGS. 3 and 4 the mirror array 38 comprises only 6x6 mirrors 40; in reality the mirror array 38 may comprise several hundreds or even several thousands mirrors 40.

The pupil forming unit 36 further comprises a prism 46 having a first plane surface 48a and a second plane surface 48b that are both inclined with respect to an optical axis OA of the illumination system 12. At these inclined surfaces 48a, 48b impinging light is reflected by total internal reflection. The first surface 48a reflects the impinging light towards the mirrors 40 of the mirror array 38, and the second surface 48b directs the light reflected from the mirrors 40 towards an exit surface 49 of the prism 46. The angular irradiance distribution of the light emerging from the exit surface 49 can thus be varied by individually tilting the mirrors 40 of the mirror array 38. More details with regard to the pupil forming unit 36 can be gleaned from US 2009/0116093 A1.

The angular irradiance distribution produced by the pupil forming unit 36 is transformed into a spatial irradiance distribution with the help of a first condenser 50. The first condenser 50, which may be dispensed with in other embodiments, directs the impinging projection light towards an irradiance adjustment unit that is denoted in its entirety with 52.

### 2. Irradiance Adjustment Unit

The irradiance adjustment unit 52 comprises a first spatial light modulator 54a and a second spatial light modulator 54b. Each spatial light modulator 54a, 54b comprises an array of light deflection elements 55 that are configured to be individually controlled. In the embodiment shown in FIG. 3 the light deflection elements 55 are micromirrors, as this can be seen in the enlarged cutout C in FIG. 3 and in the enlarged cutout C' in FIG. 5 which is a perspective view on the first spatial light modulator 54a. In contrast to the mirrors 40 of the mirror array 38, each light deflection element 55 has only two stable operating states, namely an "on" state, in which it directs impinging projection light towards a surface S, and an "off" state, in which it directs impinging projection light towards a light absorbing surface 57a or 57b. The spatial light modulators 54a, 54b may be realized as a digital mirror device (DMD), as they are commonly used in beamers, for example. Such devices may comprise up to several million micromirrors that can be switched between the two operating states many thousands times per second.

The irradiance adjustment unit 52 further comprises a first beam splitter cube 56a and a second beam splitter cube 56b. The first beam splitter cube 56a splits the projection light entering the irradiance adjustment unit 52 into first modulated light 58a and first non-modulated light 60a. The first modulated light 58a propagates along a first modulation light path 59a, in which the first spatial light modulator 54a is arranged. After reflection from the first spatial light modulator 54a, the first modulated light 58a impinges on a surface S.

The second beam splitter cube 56a splits the first non-modulated light 60a emerging from the first beam splitter cube 56a into second modulated light 58b and second non-modulated light 60b. The second modulated light 58b propagates along a second modulation light path 59b in which the second spatial light modulator 54b is arranged. After reflection from the second spatial light modulator 54b, the second modulated light 58b impinges on the surface S.

In a non-modulation light path 63, along which the first non-modulated light 60a and the second non-modulated light 60b propagate, no spatial light modulator is arranged. The non-modulated light 60a, 60b therefore propagates through the irradiance adjustment unit 52 without any modulation. It also impinges on the surface S where it superimposes with the first modulated light 58a and the second modulated light 60b.

In this embodiment the first and second modulated light 58a, 58b impinges obliquely from opposite directions on the surface S, whereas the angle of incidence of the non-modulated light 60b is 90°. In this particular application of the irradiance adjustment unit 52, the angle of incidence of the first and second modulated light 58a, 58b has little effect on the function of the illumination system 12. However, with the help of additional mirrors and beam combiners it is also possible to redirect the first and second modulated light 58a, 58b so that it impinges perpendicularly on the surface S, too.

In each modulation light path 59a, 59b an imaging lens 64a and 64b, respectively, is arranged between the spatial light modulator 54a, 54b and the surface S. Each imaging lens 64a, 64b images the spatial light modulator 54a, 54b on the surface S. Since the object planes 66, in which the light deflection elements 55 are arranged, are inclined with regard to the surface S, the imaging lenses 64a, 64b may be arranged so that the Scheimpflug condition is fulfilled. The imaging relationship between the object planes 66 ensures that the modulated irradiance distribution on the spatial light modulators 54a, 54b are reproduced, possibly with a magnification distinct from 1, on the surface S.

In this embodiment each beam splitter cube 56a, 56b has a splitting ration of 90:10. Thus 10% of the projection light is modulated by the first spatial light modulator 54a and 10% x 90% = 9% of the projection light is modulated by the second spatial light modulator 54b. The second non-modulated light 60b, which amounts to 81% of the projection light that entered the light attenuation unit 52, impinges on the surface S without undergoing any modulation. By changing the splitting ratios of the beam splitter cube 56a, 56b it is possible to set different values for the amount of light that is modulated by the spatial light modulators 54a, 54b. 3. Optical Integrator

In this embodiment the surface S illuminated by the irradiance adjustment unit 52 is the front boundary surface of an optical integrator 68. The optical integrator 68 shown in FIG. 3 comprises a first array 70 and a second array 72 of optical raster elements 74. FIG. 6 is a perspective view of the two arrays 70, 72. Each array 70, 72 comprises, on each side of a support plate, a parallel array of cylinder lenses extending along the X and the Y direction, respectively. The volumes where two cylinder lenses cross form optical raster elements 74. Thus each optical raster element 74 may be regarded as a microlens having cylindrically curved surfaces. The use of cylinder lenses is advantageous particularly in those cases in which the refractive power of the optical raster elements 74 shall be different along the X and the Y direction. A different refractive power is necessary if the square irradiance distribution on the optical integrator 68 shall be transformed into a slit-shaped illumination field 14, as this is usually the case. The surface of the optical raster elements 74 pointing towards the spatial light modulator 52 will be referred to in the following as light entrance facet 75.

The optical raster elements 74 of the first and second array 70, 72 are arranged one behind the other in such a way that one optical raster element 74 of the first array 70 is associated in a one to one correspondence with one optical raster element 74 of the second array 72. The two optical raster elements 74, which are associated with each other, are aligned along a common axis and define an optical channel. Within the optical integrator 68 a light beam which propagates in one optical channel does not cross or superimpose with light beams propagating in other optical channels. Thus the optical channels associated with the optical raster elements 74 are optically isolated from each other.

In this embodiment a pupil plane 76 of the illumination system 12 is located behind the second array 72; however, it may equally be arranged in front of it. A second condenser 78 establishes a Fourier relationship between the pupil plane 76 and a field stop plane 80 in which an adjustable field stop 82 is arranged.

The field stop plane 80 is optically conjugated to a raster field plane 84 which is located within or in close proximity to the light entrance facets 75 of the optical integrator 68. This means that each light entrance facet 75 in the raster field plane 84 is imaged onto the entire field stop plane 80 by the associated optical raster element 74 of the second array 72 and the second condenser 78. The images of the irradiance distribution on the light entrance facet 75 within all optical channels superimpose in the field stop plane 80, which results in its very uniform illumination of the mask 16. Another way of describing the uniform illumination of the mask 16 is based on the irradiance distribution which is produced by each optical channel in the pupil plane 76. This irradiance distribution is often referred to as secondary light source. All secondary light sources commonly illuminate the field stop plane 80 with projection light from different directions. If a secondary light source is "dark", no light impinges on the mask 16 from a (small) range of directions that is associated with this particular light source. Thus it is possible to set the desired angular light distribution on the mask 16 by simply switching on and off the secondary light sources formed in the pupil plane 76. This is accomplished by changing the irradiance distribution on the optical integrator 68 with the help of the pupil forming unit 36.

### 4. Field Stop Objective

The field stop plane 80 is imaged by a field stop objective 86 onto a mask plane 88 in which the mask 16 is arranged with the help of a mask stage (not shown). The adjustable field stop 82 is also imaged on the mask plane 88 and defines at least the short lateral sides of the illumination field 14 extending along the scan direction Y. Between the field stop objective 86 and the mask 16 there is a light exit 89 that may be formed by an opening or a pane of glass provided in a housing in the illumination system 10.

The pupil forming unit 36 and the first and second spatial light modulators 54a, 54b are connected to a control unit 90 which is, in turn, connected to an overall system control 92 illustrated as a personal computer. The control unit 90 is configured to control the mirrors 40 of the pupil forming unit 36 and the light deflection elements 55 of the spatial light modulators 54a, 54b in such a manner that the angular irradiance distribution in the mask plane 88 is uniform, or a desired field dependence angular irradiance distribution is obtained.

In the following it will be described how this is accomplished.

### IV. Function and Control of the Illumination System

### 1. Pupil Forming

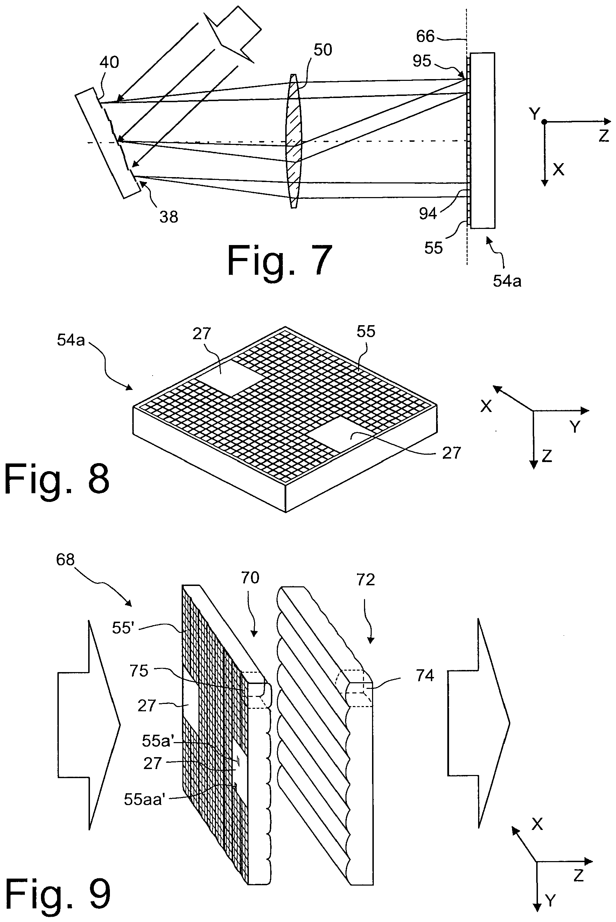

FIG. 7 schematically illustrates how the pupil forming unit 36 produces an irradiance distribution on the light deflection elements 55 of the first and second spatial light modulators 54a, 54b. For the sake of simplicity the beam splitter cubes 56a, 56b are not shown.

Each mirror 40 of the mirror array 38 is configured to illuminate a spot 94 on the object plane 66 of the spatial light modulators 54a, 54b at a position that is variable by changing a deflection angle produced by the respective mirror 40. Thus the spots 94 can be freely moved over the object planes 66 by tilting the mirrors 40 around their tilt axes. In this way it is possible to produce a wide variety of different irradiance distributions on the object plane 66. The spots 94 may also partly or completely overlap, as this is shown at 95. Then also graded irradiance distributions may be produced.

FIG. 8 is a perspective view, similar to FIG. 5, on the first spatial light modulator 54a. Here it is assumed that the pupil forming unit 36 has produced an irradiance distribution on the object plane 66 that consists of two square poles 27 each extending exactly over 6x6 light deflection elements 55. The poles 27 are arranged mirror symmetrically with respect to an YZ plane. The irradiance distribution produced on the second spatial light modulator 54b is identical.

The imaging lenses 64a, 64b form from the modulated light 58a, 58b basically identical and superimposing images of this irradiance distribution on the surface S of the optical integrator 68 (or of its light entrance facets 75), as this is shown in FIG. 9. In this context it is assumed that all light deflection elements 55 are in the "on"-state so that the irradiance distributions formed on the spatial light modulators 54a, 54b are identically reproduced (apart from a possible scaling due to a magnification of the imaging lenses 64a, 64b) on the optical integrator 68. For the sake of simplicity images of gaps that separate adjacent light deflection elements 55 of the spatial light modulators 54a, 54b are disregarded. The regular grid shown on the light entrance facets 75 represents an image of the borderlines of the light deflection elements 55, but this image does not appear outside the poles 27 and is shown in FIG. 9 only for illustrative reasons.

Additionally, the irradiance distribution produced on the spatial light modulators 54a, 54b is formed again on the surface S of the optical integrator 68 by the non-modulated light 60b. Since this non-modulated light 60b represents 81% of the entire projection light, the three irradiance distributions superimposing on the surface S are only qualitatively, but not quantitatively identical.

### 2. Field Dependence

Since the light entrance facets 75 are located in the raster field plane 84, the irradiance distribution on the light entrance facets 75 is imaged, via the optical raster elements 74 of the second array 72 and the second condenser 78, on the field stop plane 80.

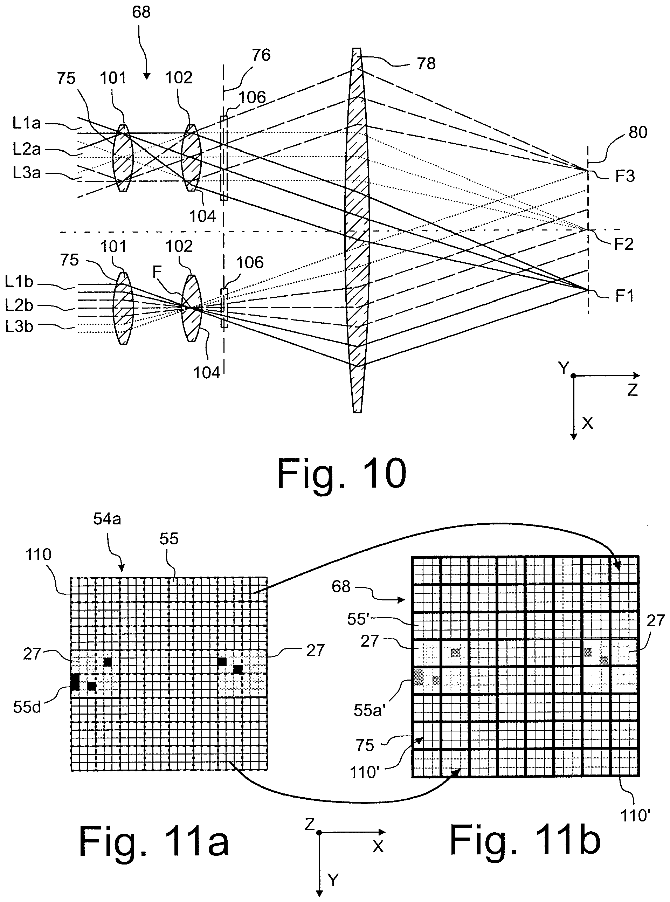

This will now be explained with reference to FIG. 10 which is an enlarged and not to scale cut-out from FIG. 3. Here only two pairs of optical raster elements 74 of the optical integrator 68, the second condenser 78 and the intermediate field stop plane 80 are schematically shown.

Two optical raster elements 74 that are associated with a single optical channel are referred to in the following as first microlens 101 and second microlens 102. The microlenses 101, 102 are sometimes referred to as field and pupil fly's eye lenses. Each pair of microlenses 101, 102 associated with a particular optical channel produces a secondary light source 106 in the pupil plane 76. In the upper half of FIG. 10 it is assumed that converging light bundles L1a, L2a and L3a illustrated with solid, dotted and broken lines, respectively, impinge on different points of the light entrance facet 75 of the first microlens 101. After having passed the two microlenses 101, 102 and the condenser 78, each light bundle L1a, L2a and L3a converges to a focal point F1, F2 and F3, respectively. From the upper half of FIG. 10 it becomes clear that points, where light rays impinge on the light entrance facet 75, and points where these light rays pass the field stop plane 80 (or any other conjugated field plane), are optically conjugate.

The lower half of FIG. 10 illustrates the case when collimated light bundles L1b, L2b and L3b impinge on different regions of the light entrance facet 75 of the first microlens 101. This is the more realistic case because the light impinging on the optical integrator 68 is usually substantially collimated. The light bundles L1b, L2b and L3b are focused in a common focal point F located in the second microlens 102 and then pass, now collimated again, the field stop plane 80. Again it can be seen that, as a result of the optical conjugation, the region where a light bundle L1b, L2b and L3b impinges on the light entrance facet 75 corresponds to the region which is illuminated in the field stop plane 80. As a matter of course, these considerations apply separately for the X and the Y direction if the microlenses 101, 102 have refractive power both along the X and Y direction.

Therefore each point on a light entrance facet 75 directly corresponds to a conjugated point in the intermediate field stop plane 80, and hence to a conjugated point in the illumination field 14 on the mask 16. By selectively influencing the irradiance at a point on a light entrance facet 75, it is thus possible to influence the irradiance of a light ray that impinges on the conjugated point in the illumination field 14 from a direction that depends on the position of the light entrance facet 75 with respect to the optical axis OA of the illumination system. The larger the distance between this light entrance facet 75 from the optical axis OA is, the larger is the angle under which the light ray impinges on the point on the mask 16.

### 3. Modifying Irradiance on Light Entrance Facets

In the illumination system 12 the irradiance adjustment unit 52 is used to adjust the irradiance on points on the light entrance facets 75. In FIG. 9 it can be seen that each pole 27 extends over a plurality of small areas 55' that are superimposed images of the light deflection elements 55 of the two spatial light modulators 54a, 54b. If one of the light deflection elements 55 of the first spatial light modulator 54a is brought into an "off" state, the conjugated area on a certain light entrance facets 75 will not be illuminated by the first spatial light modulator 54a and thus form grey spots 55a'. Since 10% of the projection light impinges on the first spatial light modulator 54a, and assuming that the corresponding light deflection element 55 of the second spatial light modulator 54b is in the "on" state, the irradiance at the grey spots 55a' is reduced by 10%.

If also the corresponding light deflection element 55 of the second spatial light modulator 54b is in the "off" state, the irradiance is further reduced by 9% to 81%. Such an area is indicated in FIG. 9 with a darker grey shade and denoted by 55aa' .

In areas on which not only the non-modulated light 60b, but also the modulated light 58a, 58b impinge, the irradiance is substantially 100%. Light losses due to the interaction of the projection light with the first and second spatial light modulators 54a, 54b are mainly caused by diffraction, the gaps between adjacent light deflection elements 55 and, if the latter are configured as micromirrors, by their non-ideal coefficient of reflection. However, these light losses are comparatively small because not 100%, but only 19% of the projection light impinges on the spatial light modulators 54a, 54b.

The attenuation of the projection light is also illustrated in FIGS. 11a and 11b which are top views on the first spatial light modulator 54a and on the optical integrator 68, respectively.

The thick dotted lines on the first spatial light modulator 54a conceptionally divide its mirror plane into a plurality of object areas 110 each comprising 3x3 light deflection elements 55. The objective 58 forms an image of each object area 110 on the optical integrator 68. This image will be referred to in the following as image area 110'. Each image area 110' completely coincides with a light entrance facet 75, i. e. the image areas 110' have the same shape, size and orientation as the light entrance facets 75. Since each object area 110 comprises 3x3 light deflection elements 55, the image areas 110' also comprise 3x3 images 55' of light deflection elements 55.

In FIG. 11a there are eight object areas 110 of the first spatial light modulator 54a that are completely illuminated by the pupil forming unit 36 with projection light. These eight object areas 110 form the two poles 27. It can be seen that in some of the object areas 110 one, two or more light deflection elements 55d represented as black squares have been controlled by the control unit 90 such that they are in an "off"-state in which impinging projection light is not directed towards the objective 58, but towards the absorber 57b. By switching light deflection elements 55 between the "on" and the "off" state it is thus possible to variably prevent projection light from impinging on corresponding regions within the image areas 110' on the light entrance facets 75, as this is shown in FIG. 11b. These regions, which form the grey spots 55a' mentioned above with reference to FIG. 9, are not dark, because they are still illuminated by the non-modulated light 60b and possibly - depending on how the second spatial light modulator 54b is controlled - by the modulated light 58b propagating along the second modulation light path 59b.

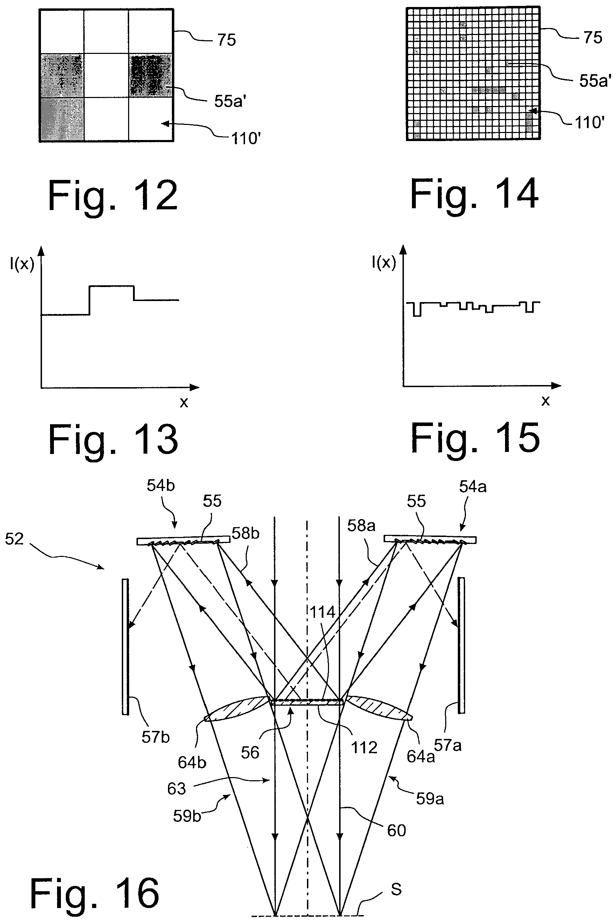

As has been explained above with reference to FIG. 10, the irradiance distribution on each light entrance facet 75 is imaged and superimposed on the field stop plane 80. If a light entrance facet 75 contains one or more grey spots 55a', as this is illustrated in FIG. 12, the irradiance distribution produced in the mask plane 88 by the associated optical channel will have grey spots at certain X positions, too. If a point on a mask passes through the illumination field 14, the total scan integrated irradiance will thus depend on the X position of the point in the illuminated field 14, as this is shown in the graph of FIG. 13. Points in the middle of the illumination field 14 will experience the highest scan integrated irradiance, because they do not pass through grey spots, and points at the longitudinal sides of the illumination field 14 will receive total irradiances that are reduced to different extents. Thus the field dependence of the angular light distribution on the mask 16 can be modified by selectively bringing one or more light deflection elements 55 of the first spatial light modulator 54a from an "on"-state into the "off"-state.

The same applies, mutatis mutandis, also for the second spatial light modulator 54b. With the help of the second spatial light modulator 54b an additional reduced irradiance level is provided. In FIG. 12 this implies that there may be spots 56a' having different grey shadings. If the splitting ratios of the first and second beam splitter cubes 56a, 56b are not identical, but different, for example 10% and 5%, respectively, even more significantly different irradiance levels are obtained.

In the foregoing it has to be assumed that each object area 110, which is imaged on one of the light entrance facets 75, contains only 3x3 light deflection elements 55. Thus the resolution along the cross-scan direction X, and also the number of scan integrated irradiance levels, that can be used to modify the field dependence of the angular light distribution is relatively coarse. If the number of light deflection elements 55 within each object area 110 is increased, this resolution can be improved.

FIG. 14 illustrates a top view on one of the light entrance facets 75 for an embodiment in which 20x20 light deflection elements 55 are contained in each object area 110. Then more complicated scan integrated irradiance distributions along the X direction can be achieved on the mask 16, as this is illustrated in the graph shown in FIG. 15.

### V. Alternative Embodiments

### 1. Second Embodiment - Symmetric Configuration

In the first embodiment described above the irradiance adjustment unit 52 comprises two beam splitting surfaces formed in the beam splitter cubes 56a, 56b. Although this results in an asymmetric cascaded configuration, the modulated light 58a, 58b impinges from opposite sides with the same angle of incidence on the surface S.

FIG. 16 shows in a meridional section an irradiance adjustment unit 52 according to a second embodiment in which the spatial light modulators 54a, 54b are arranged symmetrically with regard to a single light splitter. The light splitter of this embodiment is formed by a diffractive optical element 56 comprising a substrate 112 which supports a plurality of minute diffractive structures 114. These structures 114 usually form a regular diffraction grating, but other configurations, for example computer generated holograms, may also be envisaged.

The diffractive optical element 56 is configured such that 80% of the impinging projection light is concentrated in the zeroth diffraction order that passes the diffractive optical element 56 along the non-modulation light path 63. This portion of the impinging projection light forms the non-modulated light 60 that impinges on the surface S without interacting with any of the spatial light modulators 54a, 54b.

The remaining projection light is equally distributed among the +1 and -1 diffraction order and leaves the diffractive optical element 56 under an angle. In this manner 10% of the incoming projection light is directed towards the first spatial light modulator 54a, and 10% of the incoming projection light is directed towards the second spatial light modulator 54b.

The spatial light modulators 54a, 54b are configured in the same manner as in the first embodiment. Thus, depending on whether the light deflection elements 55 are in their on" or "off" position, the incident projection light is either directed via the imaging lenses 64a, 64b towards the surface S or on one of the light absorbing surfaces 57a, 57b. Therefore also the irradiance attenuation unit 52 shown in FIG. 16 has two modulation light paths 59a and 59b in which spatial light modulators 54a, 54b are arranged.

The irradiance attenuation unit 52 functions basically in the same way as it has been explained above with reference to the embodiment shown in FIGS. 1 to 15. By suitably controlling the light deflection elements 55 of the two spatial light modulators 54a, 54b, the irradiance distribution in the surface S can be finely adjusted, and in this manner the field dependency of the angular light distribution can be influenced as desired.

In this embodiment the irradiance of the modulated light 58a, 58b in the modulation light paths 59a, 59b is exactly equal before it impinges on the spatial light modulators 54a, 54b. However, it is also possible to modify the diffractive optical element 56 so that it splits the projection light asymmetrically between the two modulation light paths 59a, 59b.

### 2. Third embodiment - Grazing Incidence

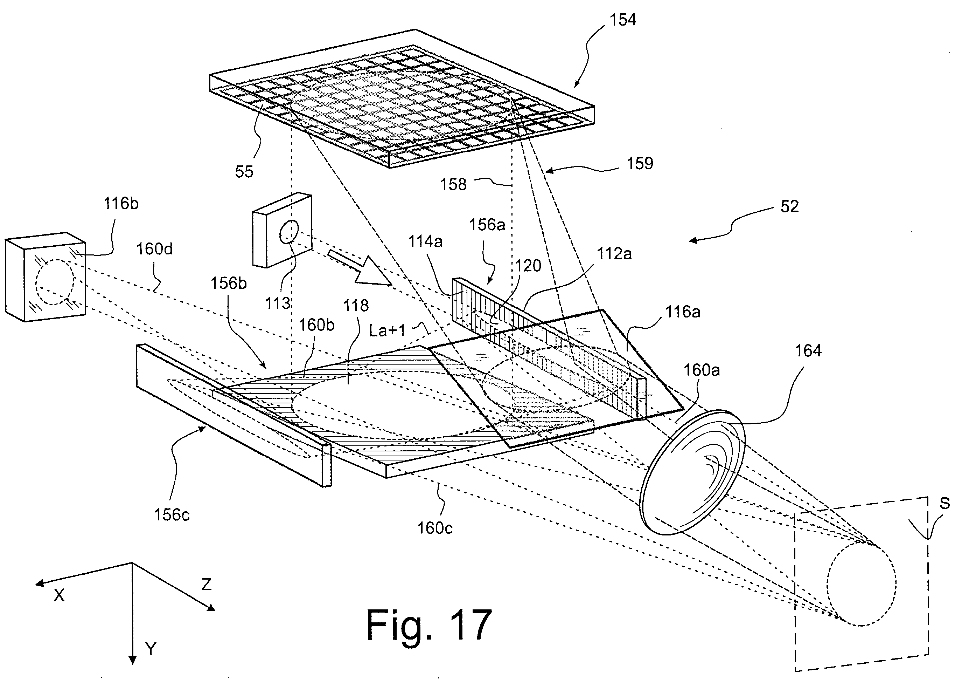

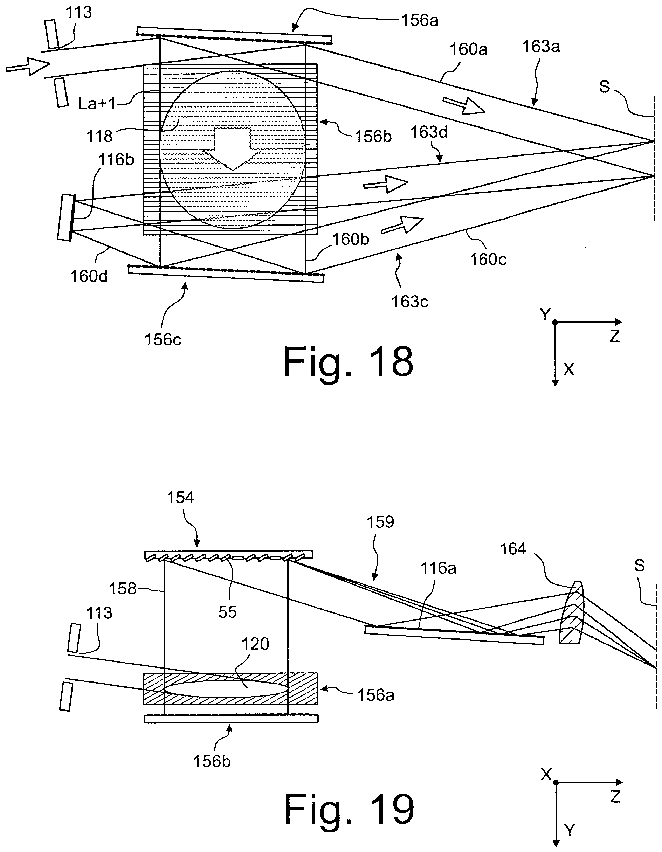

A third embodiment of an irradiance attenuation unit 52 will now be described with reference to FIGS. 17 to 19. FIG. 17 is a perspective view of the irradiance attenuation unit 52, while FIGS. 18 and 19 are sectional views in an XZ plane and an YZ plane, respectively.

It is assumed that the projection light enters the irradiance attenuation unit 52 via an aperture indicated at 113. The projection light then impinges on a first diffractive optical element 156a under a grazing incidence. In the embodiment shown the angle of incidence with regard to the normal is preferably between 75° and 88°. The first diffractive optical element 156a is a reflective element comprising a substrate 112a that supports a diffraction grating 114a.

The grating parameters are adapted to the wavelength of the projection light so that, apart from the zeroth diffraction order, only the +1 diffraction order emerges from the diffractive optical element 156a. To this end the grating period should be at least 5000 lines/mm if the wavelength of the projection light is 193 nm. The zeroth diffraction order produced by the first diffractive optical element 156a forms a first portion 160a of non-modulated light that obliquely impinges on the surface S. This can be seen best in the cross sectional view of FIG. 18.

The +1 diffraction order emerging from the first diffractive optical element 156a and indicated with La+1 impinges, again under grazing incidence, on a second diffractive optical element 156b which has - apart from being larger and being arranged in a perpendicular plane - the same constitution as the first diffractive optical element 156a. Thus the second diffractive optical element 156b splits the incident projection light La+1 into zeroth order light, which forms a second portion 160b of non-modulated light and propagates towards a third diffractive optical element 156c, and a +1 diffraction order which forms the modulated light 158 because it is diffracted towards the spatial light modulator 154, as this can best be seen in the cross sectional view of FIG. 19.

Those light deflection elements 55 that are in the "on" state reflect the impinging modulated light 158 towards a first planar mirror 116a which guides the modulated light 160 along a modulation light path 159 via an imaging lens 164 on the surface S. Similar to the other embodiments, the imaging lens 164 establishes an imaging relationship between the plane of the spatial light modulator 154 and the surface S. Thus a light bundle diverging from a point on one of the light deflection elements 55 converges on a conjugated point in the surface S.

The non-modulated zeroth order light, which emerges from the second diffractive optical element 156b and forms the second portion 160b of non-modulated light, is incident on the third diffractive optical element 156c. From the third diffractive optical element 156c all diffraction orders are guided towards the surface S. More specifically, the +1 diffraction order 160c produced by the third diffractive optical element 156c is directly guided towards the surface S, as this can best be seen in FIG. 18, and the -1 diffraction order is diffracted towards a second planar mirror 116b that reflects this portion 160d of the non-modulated light towards the surface S.

The irradiance attenuation unit 52 of the third embodiment combines very small light losses with a spatially compact design. By exploiting the grazing incidence effect, it is capable of producing from a small projection light beam a beam of modulated light 158 that has a much larger diameter when it impinges on the spatial light modulator 154. In FIG. 17 this unique property becomes clear by comparing the footprint 118 of the first order diffraction light La+1 on the second diffractive optical element 156b. This footprint 118 has a much larger size than the footprint 120 of the projection light on the first diffractive optical element 156a. Furthermore, the modulated light 158 emerging from the second diffractive optical element 156b is collimated to a very high degree when it impinges on the spatial light modulator 154. This has a positive impact on the modulation by the spatial light modulator 154.

In this embodiment the non-modulated light impinging on the surface S is a combination of the zero diffraction order light 160a produced by the first diffractive optical element and of the -1 and +1 diffraction order light 160c, 160d produced by the third diffractive optical element 156c, as this can best be seen in FIG. 18. The non-modulated light therefore propagates along different non-modulation light paths 163a, 163c and 163d.

If the lens 164 is replaced by a mirror, the irradiance attenuation unit 52 may also be used in an EUV projection apparatus using a wavelength of less than 30 nm, for example 13.5 nm.

### VI. Important Method Steps

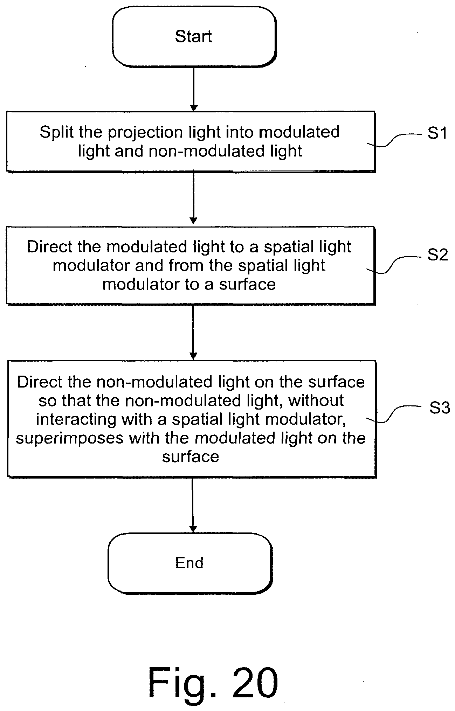

Important method steps of the present invention will now be summarized with reference to the flow diagram shown in FIG. 20.

In a first step S1 projection light is split into modulated light and non-modulated light.

In a second step S2 the modulated light is directed to a spatial light modulator and from the spatial light modulator to a surface.

In a third step the non-modulated light is directed on the surface so that non-modulated light, without interacting with the spatial light modulator, superimposes with the modulated light on the surface.

## Claims

1. An illumination system of a microlithographic apparatus (10), comprising
a) a light entrance (13) configured to receive projection light that is produced by a light source (11),
b) an irradiance adjustment unit (52) arranged to receive the projection light from the light entrance (13) and configured to adjust an irradiance distribution of the projection light on a surface (S), wherein the irradiance adjustment unit comprises
- a spatial light modulator (54a, 54b; 154) having an array of light deflection elements (55) that are configured to be individually controlled, and
- a light splitter (56a, 56b; 56; 156a) configured to split the projection light into modulated light (58a, 58b; 158) that propagates along a modulation light path (59a, 59b; 159) and non-modulated light (60a, 60b; 160a, 160c, 160d) that propagates along a non-modulation light path (63; 163a, 163c, 163d) which is distinct from the modulation light path,
wherein
- the spatial light modulator (54a, 54b; 154) is only arranged in the modulation light path (59a, 59b; 159),
- no spatial light modulator is arranged in the non-modulation light path (63; 163a, 163c, 163d), and
- the modulated light (58a, 58b; 158) and the non-modulated light (60a, 60b; 160a, 160c, 160d) superimpose on the surface.

2. The illumination system of claim 1, wherein the light splitter (56a, 56b; 56; 156a) is configured such that at least 70% of the projection light impinging on the irradiance adjustment unit propagates along the non-modulation light path (63; 163a, 163c, 163d).

3. The illumination system of claim 1 or 2, wherein the light splitter (56a, 56b; 56; 156a) comprises a diffractive optical element (56; 156a) configured to produce at least two diffraction orders if illuminated with the projection light.

4. The illumination system of claim 3, wherein the diffractive optical element (156a) is reflective and arranged such that the projection light impinges on the diffractive optical element under grazing incidence.

5. The illumination system of claim 3 or 4, wherein zeroth order light emerging from the light splitter (156a) forms a first portion (160a) of the non-modulated light, and wherein non-zeroth order light (La+1) emerging from the light splitter (156a) impinges on a second diffractive optical element (156b) under grazing incidence, which splits it into the modulated light (158) and a second portion (160b) of the non-modulated light.

6. The illumination system of claim 5, wherein the second portion (160b) of the non-modulated light impinges on a third diffractive optical element (156c) from which all diffraction orders are guided towards the surface (S).

7. The illumination system of any of the preceding claims, wherein the irradiance adjustment unit (52) comprises a further spatial light modulator having an array of further light deflection elements that are configured to be individually controlled, and wherein the light splitter splits the projection light also into a further modulated light that propagates along a further modulation light path, wherein
- the further spatial light modulator is arranged in the further modulation light path, and
- the modulated light, the further modulated light and the non-modulated light superimpose on the surface.

8. The illumination system of any of the preceding claims, comprising an objective (64a, 64b; 164) that images the spatial light modulator 68) on the surface (S).

9. The illumination system of any of the preceding claims, comprising
a) a mask plane (88) in which a mask (16) to be illuminated by the projection light can be arranged,
b) an optical integrator (68) configured to produce a plurality of secondary light sources (106), wherein the optical integrator (68) comprises a plurality of light entrance facets (75) each being associated with one of the secondary light sources (106) and arranged on the surface (S), wherein images of the light entrance facets (75) at least substantially superimpose in the mask plane (88),
c) a pupil forming unit (36) that is configured to variably illuminate the irradiance adjustment unit (52).

10. The illumination system of claim 9, wherein the pupil forming unit (36) comprises an array (38) of beam deflection elements (40), wherein each beam deflection element (40) is configured to illuminate a spot (94) on the spatial light modulator (54a, 54b; 154) at a position that is continuously variable by changing a deflection angle produced by the beam deflection element (40).

11. A method of adjusting an irradiance distribution of projection light on a surface (S) of an illumination system (12) of a microlithographic projection apparatus (10), comprising the following steps:
a) splitting the projection light into modulated light (58a, 58b; 158) and non-modulated light (60a, 60b; 160a, 160c, 160d);
b) directing the modulated light (58a, 58b,; 158) to a spatial light modulator (54a, 54b; 154) and from the spatial light modulator to the surface (S);
c) directing the non-modulated light (60a, 60b; 160a, 160c, 160d) on the surface (S) so that the non-modulated light, without interacting with a spatial light modulator, superimposes with the modulated light on the surface.

12. The method of claim 11, wherein at least 70% of the projection light propagates along a non-modulation light path (63; 163a, 163c, 163d).

13. The method of claim 11 or 12, wherein a diffractive optical element (56; 156a) splits the projection light in step a).

14. The method of claim 13, wherein the projection light impinges on the diffractive optical element (156a) under grazing incidence.

15. The method of claims 13 or 14, wherein zeroth order light emerging from the light splitter (156a) forms a first portion (160a) of the non-modulated light, and wherein non-zeroth order light (La+1) emerging from the light splitter (156a) impinges on a second diffractive optical element (156b) under grazing incidence, which splits it into the modulated light (158) and a second portion (160b) of the non-modulated light.

16. The method of claim 15, the second portion (160b) of the non-modulated light impinges on a third diffractive optical element (156c) from which all diffraction orders are guided towards the surface (S).

17. The method of any of claims 11 to 16, wherein the spatial light modulator (54a, 54b; 154) is imaged on the surface (S).

18. The method of any of claims 11 to 17, wherein
a) an optical integrator (68) produces a plurality of secondary light sources (106), wherein the optical integrator (68) comprises a plurality of light entrance facets (75) each being associated with one of the secondary light sources (106) and arranged on the surface (S), wherein images of the light entrance facets (75) are at least substantially superimposed in the mask plane (88),
b) a pupil forming unit (36) variably illuminates the irradiance adjustment unit (52).

## Patentansprüche

1. Beleuchtungssystem für eine mikrolithographische Vorrichtung (10), umfassend:
a) einen Lichteingang (13), der konfiguriert ist zum Empfangen eines Projektionslichts, das von einer Lichtquelle (11) produziert wird,
b) eine Bestrahlungseinstelleinheit (52), die angeordnet ist, um das Projektionslicht von dem Lichteingang (13) zu empfangen, und konfiguriert ist, um eine Bestrahlungsverteilung des Projektionslichts auf einer Oberfläche (S) einzustellen, wobei die Bestrahlungseinstelleinheit umfasst:
- einen räumlichen Lichtmodulator (54a, 54b; 154), der eine Anordnung von Lichtablenkungselementen (55) aufweist, die konfiguriert sind, um individuell gesteuert zu werden, und
- einen Lichtteiler (56a, 56b; 56; 156a), der konfiguriert ist zum Teilen des Projektionslichts in ein moduliertes Licht (58a, 58b; 158), das sich entlang eines Modulationslichtwegs (59a, 59b; 159) ausbreitet, und in ein nichtmoduliertes Licht (60a, 60b; 160a, 160c, 160d), das sich entlang eines Nichtmodulationslichtwegs (63; 163a, 163c, 163d) ausbreitet, der verschieden von dem Modulationslichtweg ist,
- wobei der räumliche Lichtmodulator (54a, 54b; 154) nur in dem Modulationslichtweg (59a, 59b; 159) angeordnet ist,
- einen nichträumlichen Lichtmodulator, der in dem Nichtmodulationslichtweg (63; 163a, 163c, 163d) angeordnet ist, und
- wobei sich das modulierte Licht (58a, 58b; 158) und das nichtmodulierte Licht (60a, 60b; 160a, 160c, 160d) auf der Oberfläche überlagern.

2. Beleuchtungssystem nach Anspruch 1, wobei der Lichtteiler (56a, 56b; 56; 156a) so konfiguriert ist, dass sich mindestens 70 % des Projektionslichts, das auf die Bestrahlungseinstelleinheit auftrifft, entlang des Nichtmodulationslichtwegs (63; 163a, 163c, 163d) ausbreitet.

3. Beleuchtungssystem nach Anspruch 1 oder 2, wobei der Lichtteiler (56a, 56b; 56; 156a) ein optisches Beugungselement (56; 156a) umfasst, das konfiguriert ist, um mindestens zwei Beugungsordnungen zu produzieren, wenn es mit dem Projektionslicht beleuchtet wird.

4. Beleuchtungssystem nach Anspruch 3, wobei das optische Beugungselement (156a) reflektierend ist und so angeordnet ist, dass das Projektionslicht unter einem streifenden Einfall auf das optische Beugungselement auftrifft.

5. Beleuchtungssystem nach Anspruch 3 oder 4, wobei Licht nullter Ordnung, das von dem Lichtteiler (156a) ausgeht einen ersten Anteil (160a) des nichtmodulierten Lichts bildet, und wobei das Licht nichtnullter Ordnung (La + 1), das von dem Lichtteiler (156a) ausgeht, unter einem streifenden Einfall auf ein zweites optisches Beugungselement (156b) auftrifft, das es in das modulierte Licht (158) und einen zweiten Anteil (160b) des nichtmodulierten Lichts teil.

6. Beleuchtungssystem nach Anspruch 5, wobei der zweite Anteil (160b) des nichtmodulierten Lichts auf ein drittes optisches Beugungselement (156c) auftrifft, von dem alle Beugungsordnungen in Richtung auf die Oberfläche (S) geleitet werden.

7. Beleuchtungssystem nach einem der vorhergehenden Ansprüche, wobei die Bestrahlungseinstelleinheit (52) einen weiteren räumlichen Lichtmodulator umfasst, der eine Anordnung von weiteren Lichtablenkungselementen aufweist, die konfiguriert sind, um individuell gesteuert zu werden, und wobei der Lichtteiler das Projektionslicht auch in ein weiteres moduliertes Licht teilt, das sich entlang eines weiteren Modulationslichtwegs ausbreitet,
- wobei der weitere räumliche Lichtmodulator in dem weiteren Modulationslichtweg angeordnet ist, und
- wobei sich das modulierte Licht, das weitere modulierte Licht und das nichtmodulierte Licht auf der Oberfläche überlagern.

8. Beleuchtungssystem nach einem der vorhergehenden Ansprüche, das ein Objektiv (64a, 64b; 164) umfasst, das den räumlichen Lichtmodulator (68) auf die Oberfläche (S) abbildet.

9. Beleuchtungssystem nach einem der vorhergehenden Ansprüche, umfassend:
a) eine Maskenebene (88), in der eine durch das Projektionslicht zu beleuchtende Maske (16) angeordnet werden kann,
b) einen optischen Integrator (68), der konfiguriert ist, um eine Vielzahl von sekundären Lichtquellen (106) zu produzieren, wobei der optische Integrator (68) eine Vielzahl von Lichteingangsfacetten (75) umfasst, die jeweils einer der sekundären Lichtquellen (106) zugeordnet und auf der Oberfläche (S) angeordnet sind, wobei sich Bilder der Lichteingangsfacetten (75) zumindest weitgehend in der Maskenebene (88) überlagern,
c) eine Pupillengestaltungseinheit (36), die konfiguriert ist, um die Bestrahlungseinstelleinheit (52) variabel zu beleuchten.

10. Beleuchtungssystem nach Anspruch 9, wobei die Pupillengestaltungseinheit (36) eine Anordnung (38) von Strahlablenkungselementen (40) umfasst, wobei jedes Strahlablenkungselement (40) konfiguriert ist, um einen Punkt (94) auf dem räumlichen Lichtmodulator (54a, 54b; 154) in einer Position zu beleuchten, die kontinuierlich variabel ist, indem ein von dem Strahlablenkungselement (40) produzierter Ablenkungswinkel verändert wird.

11. Verfahren zum Einstellen einer Bestrahlungsverteilung eines Projektionslichts auf einer Oberfläche (S) eines Beleuchtungssystems (12) einer mikrolithographischen Projektionsvorrichtung (10), das die folgenden Schritte umfasst:
a) Teilen des Projektionslichts in ein moduliertes Licht (58a, 58b; 158) und ein nichtmoduliertes Licht (60a, 60b; 160a, 160c, 160d);
b) Ausrichten des modulierten Lichts (58a, 58b; 158) auf einen räumlichen Lichtmodulator (54a, 54b; 154) und von dem räumlichen Lichtmodulator auf die Oberfläche (S);
c) Ausrichten des nichtmodulierten Lichts (60a, 60b; 160a, 160c, 160d) auf die Oberfläche (S), sodass sich das nichtmodulierte Licht, ohne von dem räumlichen Lichtmodulator beeinflusst zu werden, auf der Oberfläche mit dem modulierten Licht überlagert.

12. Verfahren nach Anspruch 11, wobei sich mindestens 70 % des Projektionslichts entlang eines Nichtmodulationslichtwegs (63; 163a, 163c, 163d) ausbreitet.

13. Verfahren nach Anspruch 11 oder 12, wobei ein optisches Beugungselement (56; 156a) das Projektionslicht in Schritt a) teilt.

14. Verfahren nach Anspruch 13, wobei das Projektionslicht unter einem streifenden Einfall auf das optische Beugungselement (156a) auftrifft.

15. Verfahren nach Anspruch 13 oder 14, wobei Licht nullter Ordnung, das von dem Lichtteiler (156a) ausgeht einen ersten Anteil (160a) des nichtmodulierten Lichts bildet, und wobei das Licht nichtnullter Ordnung (La + 1), das von dem Lichtteiler (156a) ausgeht, unter einem streifenden Einfall auf ein zweites optisches Beugungselement (156b) auftrifft, das es in das modulierte Licht (158) und einen zweiten Anteil (160b) des nichtmodulierten Lichts teil.

16. Verfahren nach Anspruch 15, wobei der zweite Anteil (160b) des nichtmodulierten Lichts auf ein drittes optisches Beugungselement (156c) auftrifft, von dem alle Beugungsordnungen in Richtung auf die Oberfläche (S) geleitet werden.

17. Verfahren nach einem der Ansprüche 11 bis 16, wobei der räumliche Lichtmodulator (54a, 54b; 154) auf die Oberfläche (S) abgebildet wird.

18. Verfahren nach einem der Ansprüche 11 bis 17, wobei:
a) ein optischer Integrator (68) eine Vielzahl von sekundären Lichtquellen (106) produziert, wobei der optische Integrator (68) eine Vielzahl von Lichteingangsfacetten (75) umfasst, die jeweils einer der sekundären Lichtquellen (106) zugeordnet und auf der Oberfläche (S) angeordnet sind, wobei sich Bilder der Lichteingangsfacetten (75) zumindest weitgehend in der Maskenebene (88) überlagern,
b) eine Pupillengestaltungseinheit (36) die Bestrahlungseinstelleinheit (52) variabel beleuchtet.

## Revendications

1. Système d'éclairage d'un appareil microlithographique (10), comprenant
a) une entrée de lumière (13) configurée pour recevoir une lumière de projection qui est produite par une source de lumière (11),
b) une unité de réglage d'éclairement énergétique (52) disposée pour recevoir la lumière de projection depuis l'entrée de lumière (13) et configurée pour régler une distribution d'éclairement énergétique de la lumière de projection sur une surface (S), l'unité de réglage d'éclairement énergétique comprenant
- un modulateur spatial de lumière (54a, 54b ; 154) ayant un réseau d'éléments de déviation de la lumière (55) qui sont configurés pour être contrôlés individuellement, et
- un séparateur de lumière (56a, 56b ; 56 ; 156a) configuré pour séparer la lumière de projection en une lumière modulée (58a, 58b ; 158) qui se propage le long d'un chemin de lumière avec modulation (59a, 59b ; 159) et une lumière non modulée (60a, 60b ; 160a, 160c, 160d) qui se propage le long d'un chemin de lumière sans modulation (63 ; 163a, 163c, 163d) qui est distinct du chemin de lumière avec modulation,
dans lequel
- le modulateur spatial de lumière (54a, 54b ; 154) est uniquement disposé sur le chemin de lumière avec modulation (59a, 59b ; 159),
- aucun modulateur spatial de lumière n'est disposé sur le chemin de lumière sans modulation (63 ; 163a, 163c, 163d), et
- la lumière modulée (58a, 58b ; 158) et la lumière non modulée (60a, 60b ; 160a, 160c, 160d) se superposent sur la surface.

2. Système d'éclairage de la revendication 1, dans lequel le séparateur de lumière (56a, 56b ; 56 ; 156a) est configuré de telle sorte qu'au moins 70 % de la lumière de projection frappant l'unité de réglage d'éclairement énergétique se propage le long du chemin de lumière sans modulation (63 ; 163a, 163c, 163d).

3. Système d'éclairage de la revendication 1 ou 2, dans lequel le séparateur de lumière (56a, 56b ; 56 ; 156a) comprend un élément optique diffractif (56 ; 156a) configuré pour produire au moins deux ordres de diffraction s'il est éclairé avec la lumière de projection.

4. Système d'éclairage de la revendication 3, dans lequel l'élément optique diffractif (156a) est réfléchissant et disposé de telle sorte que la lumière de projection frappe l'élément optique diffractif sous une incidence rasante.

5. Système d'éclairage de la revendication 3 ou 4, dans lequel la lumière d'ordre zéro sortant du séparateur de lumière (156a) forme une première partie (160a) de la lumière non modulée, et dans lequel la lumière non d'ordre zéro (La+1) sortant du séparateur de lumière (156a) frappe un deuxième élément optique diffractif (156b) sous une incidence rasante, lequel la sépare en la lumière modulée (158) et une deuxième partie (160b) de la lumière non modulée.

6. Système d'éclairage de la revendication 5, dans lequel la deuxième partie (160b) de la lumière non modulée frappe un troisième élément optique diffractif (156c) à partir duquel tous les ordres de diffraction sont guidés vers la surface (S).

7. Système d'éclairage de l'une quelconque des revendications précédentes, dans lequel l'unité de réglage d'éclairement énergétique (52) comprend un modulateur spatial de lumière supplémentaire ayant un réseau d'éléments de déviation de la lumière supplémentaires qui sont configurés pour être contrôlés individuellement, et dans lequel le séparateur de lumière sépare la lumière de projection également en une lumière modulée supplémentaire qui se propage le long d'un chemin de lumière avec modulation supplémentaire, dans lequel
- le modulateur spatial de lumière supplémentaire est disposé sur le chemin de lumière avec modulation supplémentaire, et
- la lumière modulée, la lumière modulée supplémentaire et la lumière non modulée se superposent sur la surface.

8. Système d'éclairage de l'une quelconque des revendications précédentes, comprenant un objectif (64a, 64b ; 164) qui forme l'image du modulateur spatial de lumière (68) sur la surface (S).

9. Système d'éclairage de l'une quelconque des revendications précédentes, comprenant
a) un plan de masque (88) dans lequel un masque (16) devant être éclairé par la lumière de projection peut être disposé,
b) un intégrateur optique (68) configuré pour produire une pluralité de sources de lumière secondaire (106), l'intégrateur optique (68) comprenant une pluralité de facettes d'entrée de lumière (75), chacune étant associée à une des sources de lumière secondaire (106) et disposée sur la surface (S), des images des facettes d'entrée de lumière (75) se superposant au moins en grande partie dans le plan de masque (88),
c) une unité formant pupille (36) qui est configurée pour éclairer de façon variable l'unité de réglage d'éclairement énergétique (52).

10. Système d'éclairage de la revendication 9, dans lequel l'unité formant pupille (36) comprend un réseau (38) d'éléments de déviation de faisceau (40), chaque élément de déviation de faisceau (40) étant configuré pour éclairer une tache (94) sur le modulateur spatial de lumière (54a, 54b ; 154) à une position que l'on peut faire varier en continu en modifiant un angle de déviation produit par l'élément de déviation de faisceau (40).

11. Procédé de réglage d'une distribution d'éclairement énergétique d'une lumière de projection sur une surface (S) d'un système d'éclairage (12) d'un appareil de projection microlithographique (10), comprenant les étapes suivantes :
a) séparer la lumière de projection en une lumière modulée (58a, 58b ; 158) et une lumière non modulée (60a, 60b ; 160a, 160c, 160d) ;
b) diriger la lumière modulée (58a, 58b ; 158) jusqu'à un modulateur spatial de lumière (54a, 54b ; 154) et depuis le modulateur spatial de lumière jusqu'à la surface (S) ;
c) diriger la lumière non modulée (60a, 60b ; 160a, 160c, 160d) sur la surface (S) de telle sorte que la lumière non modulée, sans interagir avec un modulateur spatial de lumière, se superpose à la lumière modulée sur la surface.

12. Procédé de la revendication 11, dans lequel au moins 70 % de la lumière de projection se propage le long d'un chemin de lumière sans modulation (63 ; 163a, 163c, 163d).

13. Procédé de la revendication 11 ou 12, dans lequel un élément optique diffractif (56 ; 156a) sépare la lumière de projection à l'étape a).

14. Procédé de la revendication 13, dans lequel la lumière de projection frappe l'élément optique diffractif (156a) sous une incidence rasante.

15. Procédé des revendications 13 ou 14, dans lequel la lumière d'ordre zéro sortant du séparateur de lumière (156a) forme une première partie (160a) de la lumière non modulée, et dans lequel la lumière non d'ordre zéro (La+1) sortant du séparateur de lumière (156a) frappe un deuxième élément optique diffractif (156b) sous une incidence rasante, lequel la sépare en la lumière modulée (158) et une deuxième partie (160b) de la lumière non modulée.

16. Procédé de la revendication 15, dans lequel la deuxième partie (160b) de la lumière non modulée frappe un troisième élément optique diffractif (156c) à partir duquel tous les ordres de diffraction sont guidés vers la surface (S).

17. Procédé de l'une quelconque des revendications 11 à 16, dans lequel l'image du modulateur spatial de lumière (54a, 54b ; 154) est formée sur la surface (S).

18. Procédé de l'une quelconque des revendications 11 à 17, dans lequel
a) un intégrateur optique (68) produit une pluralité de sources de lumière secondaire (106), l'intégrateur optique (68) comprenant une pluralité de facettes d'entrée de lumière (75), chacune étant associée à une des sources de lumière secondaire (106) et disposée sur la surface (S), des images des facettes d'entrée de lumière (75) se superposant au moins en grande partie dans le plan de masque (88),
b) une unité formant pupille (36) éclaire de façon variable l'unité de réglage d'éclairement énergétique (52).
